(19) Europäisches Patentamt
European Patent Office
Office européen des brevets

(11) **EP 2 633 624 B1**

(12) **EUROPÄISCHE PATENTSCHRIFT**

(45) Veröffentlichungstag und Bekanntmachung des Hinweises auf die Patenterteilung:
**18.04.2018   Patentblatt 2018/16**

(21) Anmeldenummer: **11760723.4**

(22) Anmeldetag: **25.08.2011**

(51) Int Cl.:
*H03K 17/97* *(2006.01)*      *H01H 36/00* *(2006.01)*

(86) Internationale Anmeldenummer:
**PCT/EP2011/064664**

(87) Internationale Veröffentlichungsnummer:
**WO 2012/055604 (03.05.2012 Gazette 2012/18)**

(54) **ELEKTRONISCHES GERÄT UND VERFAHREN ZUR INBETRIEBNAHME EINES ELEKTRONISCHEN GERÄTES**

ELECTRONIC DEVICE AND METHOD FOR OPERATING AN ELECTRONIC DEVICE

DISPOSITIF ÉLECTRONIQUE ET PROCÉDÉ DE MISE EN SERVICE D'UN  DISPOSITIF ÉLECTRONIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.10.2010   DE 102010043026**

(43) Veröffentlichungstag der Anmeldung:
**04.09.2013   Patentblatt 2013/36**

(73) Patentinhaber: **Endress+Hauser SE+Co. KG**
**79689 Maulburg (DE)**

(72) Erfinder:
• **SCHLACHTER, Marc**
**79664 Wehr (DE)**

• **DIETERLE, Roland**
**85276 Pfaffenhofen (DE)**
• **GIRARDEY, Romuald**
**68330 Huningue (FR)**

(74) Vertreter: **Andres, Angelika Maria**
**Endress+Hauser (Deutschland) AG+Co. KG**
**PatServe**
**Colmarer Strasse 6**
**79576 Weil am Rhein (DE)**

(56) Entgegenhaltungen:
**WO-A1-2005/038350      WO-A1-2007/134287**
**DE-A1-102004 036 324    US-A- 5 201 838**
**US-A- 5 278 543**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft ein elektronisches Gerät und ein Verfahren zur Inbetriebnahme eines elektronischen Geräts. Derartige elektronisches Geräte können beispielsweise Messumformer der industriellen Prozessmesstechnik sein, welche Prozessparameter wie Druck, Füllstand, Temperatur, Durchfluss, pH oder eine andere analytische Größe mittels eines entsprechenden Sensors erfassen, und ein Messsignal des Sensors aufbereiten und in geeigneter Weise einem Leitsystem zur Verfügung stellen, beispielsweise als Stromsignal, insbesondere zwischen 4 und 20 mA oder als digitales Signal in einem der gängigen Feldbusformate, beispielsweise Profibus, Foundation Fieldbus oder HART.

Insoweit, als derartige Messumformer oft unter adversen Umweltbedingungen eingesetzt werden, versucht man Durchbrüche in den Gehäusen der Messumformer zu vermeiden, da durch solche Durchbrüche korrosive oder explosive Medien in das Gehäuse des Messumformers eindringen könnten. Damit ist die Bedienbarkeit der Messumformer über Tasten mit galvanischen Kontakten und mit Schaltern eingeschränkt. Um dennoch eine Bedienbarkeit der Messumformer zu ermöglichen, werden beispielsweise Taster mit einem Magnetkörper verwendet, die bezüglich des Messumformergehäuses definiert positioniert und beweglich sind, um mittels ihres Magnetfelds einen Magnetschalter oder Hallsensor im Inneren des Gehäuses zu betätigen.

So offenbart die Offenlegungsschrift DE102004036324A1 einen Magnetschalter für einen Messumformer, bei welchem ein Trägerkörper, welcher einen Magnetkörper in asymmetrischer Position enthält, in unterschiedlichen Orientierungen in ein Sackloch eingeführt werden kann, welches an den Innenraum eines Gehäuses angrenzt, wobei je nach der Orientierung des Magnetkörpers im Sackloch ein Hall-Sensor im Inneren des Gehäuses unterschiedlich von dem Magnetkörper beeinflusst wird. Über die Auswahl der Orientierung des Magnetkörpers kann damit zwischen zwei Betriebsarten des Messumformers gewählt werden.

Das europäische Patent EP0 383 823 B1 offenbart einen Messumformer, bei welchem Nullpunkt und Steilheit mittels magnetischer Schalter eingestellt werden können, wobei die magnetischen Schalter jeweils einen Magneten aufweisen, der in einem Sackloch beweglich ist, um einen in einem Elektronikgehäuse des Messumformers angeordneten Reed-Kontakt, der benachbart zur Wand des Sacklochs positioniert ist, zu betätigen.

Im Hinblick auf Plattformkonzepte kann es jedoch durchaus vorteilhaft sein, einfache Gerätevarianten ohne Magnetschalter anzubieten, wenn die durch die Magnetschalter zu erfolgenden Bedienfunktionen nicht erforderlich sind.

In diesem Fall ist jedoch dafür Sorge zu tragen, dass der Verzicht auf die Magnetkörper noch immer den Betrieb des elektronischen Geräts mit einer standardisierten elektronischen Schaltung ermöglicht, dass also eine Steuer- und Auswerteschaltung geeignet ist, in beiden Varianten eines elektronisches Geräts zuverlässig zu funktionieren. Dies bedeutet im Einzelnen, dass die Schaltung in der Lage ist, die Anwesenheit eines Magneten zu erkennen und von gegebenenfalls auftretenden magnetischen Störfeldern zu unterscheiden. Es ist daher die Aufgabe der vorliegenden Erfindung, ein elektronisches Gerät und ein Verfahren zu dessen Inbetriebnahme bereitzustellen, wobei das elektronische Gerät sowohl mit Magnetschaltern als auch ohne Magnetschalter zuverlässig betrieben werden kann.

Die Aufgabe wird erfindungsgemäß gelöst durch das elektronische Gerät gemäß Anspruch 1. Der Referenzwert kann beispielsweise mindestens etwa ein Viertel des Abstands, insbesondere mindestens den halben Abstand, und weiterhin mindestens drei Viertel des Abstands zwischen der ersten oder zweiten Position des Magnetkörpers betragen.

In einer Weiterbildung der Erfindung umfasst die Magnetkörperführung ein Sackloch in dem Gehäuse, wobei die erste definierte Magnetkörperposition in Längsrichtung des Sacklochs von der zweiten definierten Magnetkörperposition beabstandet ist.

In einer Ausgestaltung dieser Weiterbildung der Erfindung ist der erste Hallsensor positioniert, um eine Komponente des Magnetfelds zu erfassen, die im wesentlichen senkrecht zur Längsrichtung des Sacklochs verläuft. In einer weiteren Ausgestaltung dieser Weiterbildung de Erfindung ist der zweite Hallsensor positioniert, um eine Komponente des Magnetfelds zu erfassen, die im wesentlichen senkrecht zur Längsrichtung des Sacklochs verläuft, wobei der Wert der mit dem ersten Hallsensor erfassten Komponente des lokalen Magnetfelds insbesondere ein entgegengesetztes Vorzeichen zu dem Wert der mit dem zweiten Hallsensor erfassten Komponente des lokalen Magnetfelds aufweist, wenn sich ein Magnetkörper in der Magnetkörperführung befindet, und wenn der Magnetkörper in einer ersten definierten Magnetkörperposition (a) positioniert ist.

In einer Weiterbildung der Erfindung gilt für den Betrag eines Verhältnisses R einer Signalsumme zu einer Signaldifferenz von Signalen $S_1$, $S_2$ der Hallsensoren, welche die jeweils von dem ersten und dem zweiten Hallsensor gemessenen Komponenten repräsentieren:

$$R := |(S_1 + S_2)| / (|S_1| + |S_2|) < m,$$

wobei $m < 0{,}4$, insbesondere $m < 0{,}2$, vorzugsweise $m < 0{,}1$, wenn sich ein Magnetkörper in der Magnetkörperführung befindet, und wenn der Magnetkörper in einer ersten definierten Magnetkörperposition (a) positioniert ist. Die Steuer- und Auswerteschaltung kann weiterhin einen Eingang zum Empfang der Signale $S_1$, $S_2$ des ersten und zweiten Hallsensors aufweisen und, beispielsweise im Falle einer analogen Auswertung der Signale, dazu eingerichtet sein, die Anwesenheit eines Magnetkörpers in der ersten definierten Magnetkörperposition festzustellen, wenn R < m.

In einer anderen Weiterbildung der Erfindung weist die Steuer- und Auswerteschaltung einen Eingang zum Empfang der Signale $S_1$, $S_2$ des ersten und zweiten Hallsensors und eine Diskriminatorschaltung auf zum Abbilden der Signale $S_1$, $S_2$ der Hallsensoren auf definierte

Zustandswerte $Z_1$, $Z_2$, welche jeweils einen Wert aus der Menge {-1; 0; +1} annehmen können, und wobei die Steuer- und Auswerteschaltung dazu eingerichtet ist, die Anwesenheit eines Magnetkörpers in der ersten definierten Magnetkörperposition festzustellen, wenn gilt $Z_1 \neq Z_2$.

In einer Ausgestaltung dieser Weiterbildung der Erfindung können die definierte Zustandswerte $Z_1$, $Z_2$ jeweils nur einen Wert aus der Menge {0; 1} annehmen, wobei die Steuer- und Auswerteschaltung dazu eingerichtet ist, die Anwesenheit eines Magnetkörpers in der ersten definierten Magnetkörperposition festzustellen, wenn gilt ($Z_1 = 0$ und $Z_2 = 1$) oder ($Z_1 = 1$ und $Z_2 = 0$).

In einer Weiterbildung der Erfindung gilt für den Abstand d des ersten Hall-Sensors vom zweiten Hall-Sensor in Richtung der Bewegung der Magnetkörperführung: d > l/4, insbesondere d > l/2, und vorzugsweise d > l/2l, wobei l die Längserstreckung des Magnetkörpers in Richtung der Bewegung der Magnetkörperführung ist.

In einer Weiterbildung der Erfindung umfasst das elektronische Gerät einen Messumformer zum Erfassen einer Prozessmessgröße, wie Druck, Füllstand, Temperatur, Durchfluss, pH-Wert, Leitfähigkeit, Trübung, Konzentration des gelösten Sauerstoffs, einen analytischen Summenparameter, wie den Gesamtgehalt organischen Kohlenstoffs, oder eine andere Eigenschaft eines Prozessmediums umfasst.

Die Erfindung wird nun anhand des in den Figuren gezeigten Ausführungsbeispiels erläutert. Es zeigt:

Fig. 1a: einen Längsschnitt durch ein Ausführungsbeispiel eines erfindungsgemäßen elektronischen Geräts mit einem Magnetschalter in einer ersten Position;

Fig. 1b: einen Längsschnitt durch das Gerät aus Fig. 1a mit dem Magnetschalter in einer zweiten Position;

Fig. 2: ein Koordinatensystem zur Beschreibung der vorliegenden Erfindung;

Fig. 3a: ein Flussdiagramm zur Inbetriebnahme eines erfindungsgemäßen elektronischen Geräts;

Fig. 3b: ein Flussdiagramm zur Abfrage, ob ein Magnet vorhanden ist;

Fig. 3c: ein Flussdiagramm zum Betreiben des elektronischen Geräts, für den Fall, dass ein Magnet vorhanden ist; und

Fig. 4: ein Flussdiagramm zu einer binären Abfrage, ob ein Magnet vorhanden ist.

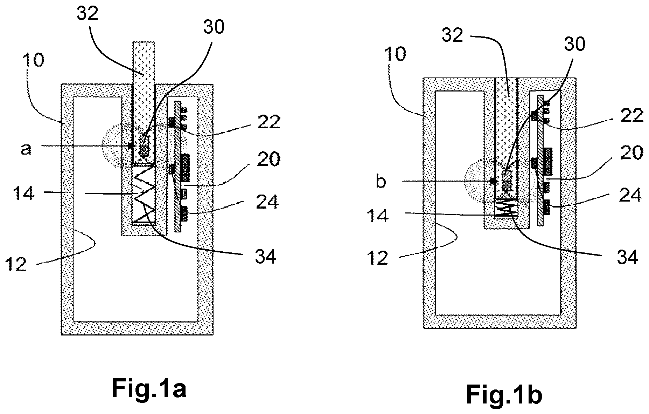

Das in Fign. 1a und 1b gezeigte, elektronische Gerät umfasst ein Gehäuse 10, welches in seinem Inneren eine Kammer 12 aufweist, wobei in einer Wand des Gehäuses 10 ein Sackloch 14 ausgebildet ist, welches von der Außenseite des Gehäuses zugänglich ist. Angrenzend an eine Wand es Sacklochs ist in der Kammer 12 eine Steuer- und Auswerteschaltung 20 angeordnet, welche das elektronische Gerät steuert und Signale einer im Folgenden näher erläuterten magnetischen Bedienvorrichtung auswertet, wozu die Schaltungsanordnung 20 zwei Hall-Sensoren aufweist, die in Längsrichtung des Sacklochs 14 beabstandet zueinander angeordnet sind. In dem Sackloch 14, welches als Magnetkörperführung dient, kann nun ein Magnetkörper 30, der in einen Taster 32 eingebettet ist, gegen eine Rückstellfeder 34 zwischen einer Ruheposition a und einer Tastposition b bewegt werden.

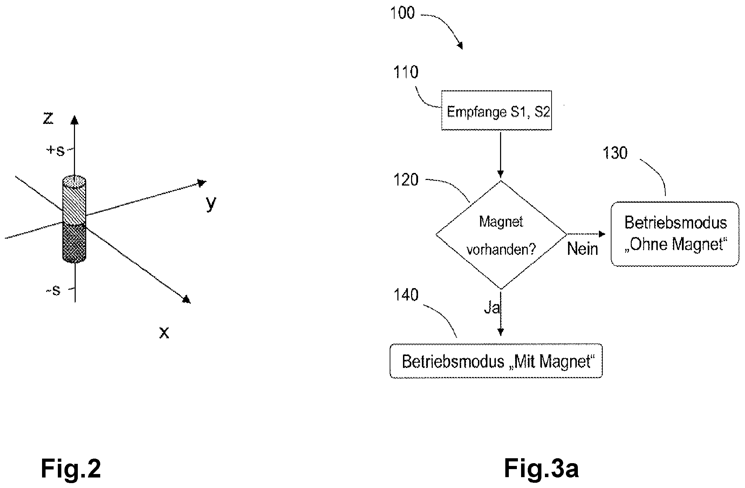

Eine derzeit bevorzugte Variante zur Orientierung der beiden Hall-Sensoren 20, 22 ist nun anhand der Fig. 2 beschrieben. Der Magnetkörper 30 kann in dem Sackloch 14 mit seiner Längsachse in Z-Richtung bewegt werden, wobei die Längsachse und die Feldachse des Magnetkörpers 30 parallel zur Z-Achse ausgerichtet ist und durch X = 0 und Y = 0 verläuft. Die Hall-Sensoren sind nun beispielsweise bei X = 0, Y = 1 und Z = +/-s positioniert. Wenn die Hall-Sensoren in dieser Anordnung mit einem Strom in Z-Richtung betrieben werden und die Hall-Spannung in X-Richtung erfasst wird, so kann anhand dessen die Feldkomponente des Magnetfelds vom Magnetkörper 30 in Y-Richtung bestimmt werden. Für den Fall, dass der Magnetkörper bezüglich seiner Z-Koordinate am Ursprung, also genau in der Mitte zwischen den beiden Hall-Sensoren positioniert ist, bedeutet dies, dass die detektierte Y-Komponente des Magnetfelds an dem ersten Hall-Sensor 22 den negativen Wert der Y-Komponente des Magnetfelds am zweiten Hall-Sensor 24 entspricht. Wäre nun kein Magnet vorhanden, und würde ein externes Magnetfeld auf das elektronische Gerät einwirken, so wäre es praktisch unmöglich, dass die Y-Komponente des Magnetfelds am Ort des ersten Sensors dem negativen Wert der Y-Komponente des Magnetfelds des zweiten Sensors aufweist. Auf diese Weise ist bei Anwesenheit eines Magnetfelds sicher zu entscheiden, ob das Magnetfeld durch einen Magnetkörper im Sackloch verursacht ist oder von einer externen Feldquelle.

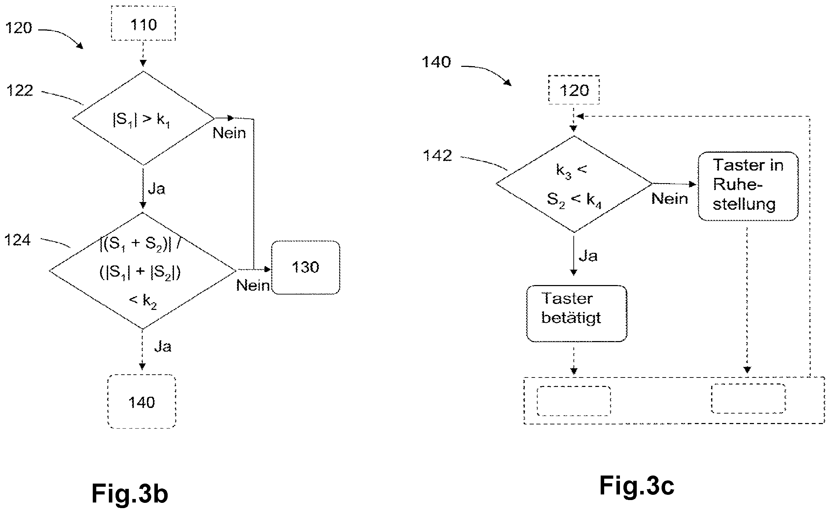

Fig. 3 mit den Teilfiguren 3a, 3b und 3c zeigt nun ein Verfahren 100 für Inbetriebnahme des elektronischen Geräts, wobei in einem ersten Verfahrensschritt 110 die Signale S1, S2 der Hall-Sensoren empfangen werden und in einem Folgeschritt 120 anhand der Signale entschieden wird, ob ein Magnetkörper in dem Sackloch 14 vorhanden ist. Falls ja, geht das elektronische Gerät in einem Folgeschritt 140 in einen Betriebsmodus "mit Magnet". In diesem Betriebsmodus fragt das elektronische Gerät weiterhin die Sensorsignale S1, S2 ab, um über den Taster 32 gegebene Steuerbefehle zu erkennen. Falls bei der Inbetriebnahme kein Magnet erkannt wird, geht das elektronische Gerät in den Betriebsmodus "ohne Magnet", wonach Signale S1, S2 der Hall-Sensoren nicht mehr ausgewertet werden.

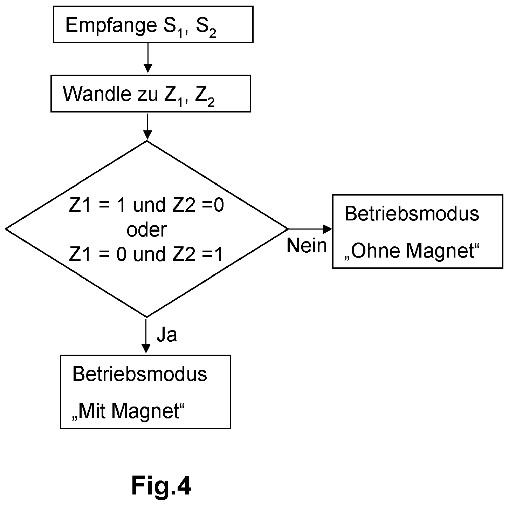

Fig. 3b erläutert nun die Abfrage 120 zum Feststellen, ob ein Magnet vorhanden ist, für eine analoge Auswertung der Signale S1, S2 der beiden Hall-Sensoren. Bei dieser Auswertung wird zunächst davon ausgegangen, dass sich der Magnetkörper, sofern vorhanden, in einer Ruheposition befindet, in der sein Magnetfeld von dem ersten Hall-Sensor detektierbar ist und zu einem Signal führt, welches seinen Schwellwert $K_1$ übersteigt. Falls eine solche Mindestgröße des Feldes nicht detektierbar ist, kann ohne weiteres davon ausgegangen werden, dass kein Magnetkörper vorhanden ist und das elektronische Gerät geht sofort in den Betriebsmodus "ohne Magnet" 130. Falls jedoch der Sensor S1 ein immerhin starkes Signal erfasst, ist in einem zweiten Schritt 124 zu klären, ob es sich hierbei um eine Störgröße oder tatsächlich um das Feld eines ordnungsgemäß eingebrachten Magnetkörpers handelt. Hierzu wird die Summe der Signale des ersten Sensors und des zweiten Sensors S1 und S2 durch die Differenz dieser Signale geteilt. Insofern die Signale bei einem ordnungsgemäß eingebrachten Magnetkörper entgegen gesetzte Vorzeichen aufweisen, bedeutet dies, dass der Testausdruck bei einem ideal positionierten Magnetkörper den Wert 0 annehmen würde. Insoweit, als dies technisch kaum in der erforderlichen Genauigkeit realisierbar ist, erfolgt hier ein Schwerwertvergleich mit einer Konstante $k_2$. Wenn $k_2$ unterschritten wird, kann davon ausgegangen werden, dass ein Magnetkörper ordnungsgemäß vorhanden ist, und das elektronische Gerät geht in den Betriebsmodus 140 "Magnet vorhanden". Falls die Konstante $k_2$ überschritten wird, geht das elektronische Gerät wiederum in den Betriebsmodus "ohne Magnet" 130. Fig. 3c zeigt schließlich ein Schema für die Abfrage in der Position des in den Taster 32 integrierten Magnetkörpers 30. In einem Schritt 142 ist nahezu festzustellen, ob das Signal S2 des zweiten Sensors einen Wert zwischen einer dritten Konstante und einer vierten Konstante annimmt, was dann der Fall ist, wenn der Magnetkörper in das Sackloch hineinbewegt wird. In diesem Fall detektiert die Auswerteschaltung den Zustand-Taster betätigt. Falls das Signal außerhalb des Intervalls $[k_3, k_4]$ liegt, stellt die Auswerteschaltung fest, dass der Taster in seiner Ruhestellung (a) ist. Abschließend zeigt Fig. 4 eine digitale Frage, ob ein Magnetkörper im Sackloch vorhanden ist. Hierzu werden die Signale S1, S2 der beiden Hall-Sensoren zunächst in binäre Zustandswerte $Z_1$, $Z_2$ gewandelt, welche dann einer Abfrage zugeführt werden, wobei die Anwesenheit eines Magneten festgestellt wird, wenn $Z_1 = 1$ und $Z_2 = 0$ oder $Z_1 = 0$ und $Z_2 = 1$. Entsprechend der

getroffenen Feststellung wird der Betriebsmodus "mit Magnet" oder der Betriebsmodus "ohne Magnet" gewählt.

Die Abbildungsvorschrift der zunächst möglicherweise antisymmetrischen Signale $S_1$ und $S_2$ auf die Werte 1 und 0 kann im Einzelnen die Addition einer Konstanten und eine Schwellwertabfrage erfordern. Dies ist jedoch dem Fachmann geläufig und braucht hier nicht im Einzelnen erläutert zu werden.

## Patentansprüche

1. Elektronisches Gerät, nämlich ein Messumformer zum Erfassen einer Prozessmessgröße, wobei das elektronische Gerät mittels eines Magnetkörpers bedienbar ist, wobei das elektronische Gerät einen Betriebsmodus "mit Magnet" und einen zweiten Betriebsmodus "ohne Magnet" aufweist, wobei das elektronische Gerät umfasst:

   ein Gehäuse (10), welches in seinem Innern mindestens eine Kammer (12) aufweist;
   eine Magnetkörperführung (14), zum Aufnehmen und Führen des Magnetkörpers (30), wobei die Magnetkörperführung die Positionierung eines aufgenommenen Magnetkörpers in mindestens zwei definierten Magnetkörperpositionen (a, b) bezüglich des Gehäuses ermöglicht;
   eine Steuer- und Auswertungsschaltung (20), welche in der Kammer angeordnet, ist mit
   einem ersten Hall-Sensor (22) zum Erfassen mindestens einer Komponente eines ersten lokalen Magnetfelds am Ort des ersten Hall-sensors und zum Bereitstellen eines ersten Signals welches von dem erfassten lokalen Magnetfeld an dem ersten Ort abhängt, wobei der erste Hall-Sensor bezüglich des Gehäuses eine erste definierte Position aufweist; und
   einem zweiten Hall-Sensor(24), zum Erfassen mindestens einer Komponente eines zweiten lokalen Magnetfelds am Ort des zweiten Hallsensors und zum Bereitstellen eines zweiten Signals welches von dem erfassten lokalen Magnetfeld an dem zweiten Ort abhängt, wobei der zweite Hall-Sensor bezüglich des Gehäuses eine zweite definierte Position aufweist;
   wobei die Steuerschaltung geeignet ist bei einer Inbetriebnahme anhand des ersten Signals ($S_1$) bzw. einer daraus abgeleiteten ersten digitalen Zustandsgröße ($Z_1$) und anhand des zweiten Signals ($S_2$) bzw. einer daraus abgeleiteten zweiten digitalen Zustandsgröße ($Z_2$) festzustellen ob ein Magnetkörper in der Magnetkörperführung vorhanden ist,
   wobei falls ja, das Gerät in den Betriebsmodus "mit Magnet" geht,
   in dem die Steuerschaltung anhand eines der Signale oder beider Signale ($S_1$, $S_2$) bzw. einer digitalen Zustandsgröße oder beider digitalen Zustandsgrößen ($Z_1$, $Z_2$) feststellt, ob sich der Magnetkörper in der ersten definierten Magnetkörperposition befindet oder aus dieser Position, insbesondere um mindestens einen Referenzwert bewegt worden ist, um Steuerbefehle zu erkennen, und
wobei falls nein, das Gerät in den Betriebsmodus "ohne Magnet" geht, in dem Signale ($S_1$, $S_2$) der Hall-Sensoren nicht mehr ausgewertet werden.

2. Elektronisches Gerät nach Anspruch 1, wobei die Magnetkörperführung ein Sackloch in dem Gehäuse umfasst, und wobei die erste definierte Magnetkörperperposition in Längsrichtung des Sacklochs von der zweiten definierten Magnetkörperposition beabstandet ist.

3. Elektronisches Gerät nach Anspruch 2, wobei der erste Hallsensor positioniert ist, um eine Komponente des Magnetfelds zu erfassen, die im wesentlichen senkrecht zur Längsrichtung des Sacklochs verläuft.

4. Elektronisches Gerät nach Anspruch 2 oder 3, wobei der zweite Hallsensor positioniert ist, um eine Komponente des Magnetfelds zu erfassen, die im wesentlichen senkrecht zur Längsrichtung des Sacklochs verläuft.

5. Elektronisches Gerät nach Anspruch 4, wobei der Wert der mit dem ersten Hallsensor erfassten Komponente des lokalen Magnetfelds ein entgegengesetztes Vorzeichen zu dem Wert der mit dem zweiten Hallsensor erfassten Komponente des lokalen Magnetfelds aufweist, wenn sich ein Magnetkörper in der Magnetkörperführung befindet, und wenn der Magnetkörper in einer ersten definierten Magnetkörperperposition (a) positioniert ist.

6. Elektronisches Gerät nach Anspruch 4, wobei für den Betrag eines Verhältnisses R einer Signalsumme zu einer Signaldifferenz von Signalen $S_1$, $S_2$ der Hallsensoren, welche die jeweils von dem ersten und dem zweiten Hallsensor gemessenen Komponenten repräsentieren, gilt:

$$R := |(S_1 + S_2)| / (|S_1| + |S_2|) < m,$$

wobei m = 0,4, insbesondere m = 0,2, vorzugsweise m = 0,1,
wenn sich ein Magnetkörper in der Magnetkörperführung befindet, und wenn der Magnetkörper in einer ersten definierten Magnetkörperperposition (a) positioniert ist.

7. Elektronisches Gerät nach Anspruch 6, wobei die Steuer- und Auswerteschaltung einen Eingang zum Empfang der Signale $S_1$, $S_2$ des ersten und zweiten Hallsensors aufweist, und dazu eingerichtet ist, die Anwesenheit eines Magnetkörpers in der ersten definierten Magnetkörperperposition festzustellen, wenn R < m.

8. Elektronisches Gerät nach einem der vorhergehenden Ansprüche, wobei die Steuer- und Auswerteschaltung einen Eingang zum Empfang der Signale $S_1$, $S_2$ des ersten und zweiten Hallsensors und eine Diskriminatorschaltung aufweist zum Abbilden der Signale $S_1$, $S_2$ der Hallsensoren auf definierte Zustandswerte $Z_1$, $Z_2$, welche jeweils einen Wert aus der Menge {-1; 0; +1} annehmen können, und wobei die Steuer- und Auswerteschaltung dazu eingerichtet ist, die Anwesenheit eines Magnetkörpers in der ersten definierten Magnetkörperperposition festzustellen, wenn gilt $Z_1 \neq Z_2$.

9. Elektronisches Gerät nach Anspruch 8, wobei die definierte Zustandswerte $Z_1$, $Z_2$ jeweils einen Wert aus der Menge {0; 1} annehmen können, und wobei die Steuer- und Auswerteschaltung dazu eingerichtet ist, die Anwesenheit eines Magnetkörpers in der ersten definierten Magnetkörperperposition festzustellen, wenn gilt ($Z_1 = 0$ und $Z_2 = 1$) oder ($Z_1 = 1$ und $Z_2 = 0$).

10. Elektronisches Gerät, nach einem der vorhergehenden Ansprüche, wobei für den Abstand a des ersten Hall-Sensors vom zweiten Hall-Sensor in Richtung der Bewegung der Magnetkörperführung gilt: a > l/4, insbesondere a > l/2, und vorzugsweise a > l/2l, wobei l die Längserstreckung des Magnetkörpers in Richtung der Bewegung der Magnetkörperführung ist.

11. Elektronisches Gerät nach einem der vorhergehenden Ansprüche, wobei die Prozessmessgröße Druck, Füllstand, Temperatur, Durchfluss, pH-Wert, Leitfähigkeit, Trübung, Konzentration des gelösten Sauerstoffs, einen analytischen Summenparameter, wie den Gesamtgehalt organischen Kohlenstoffs, oder eine andere Eigenschaft eines Prozessmediums umfasst.

**Claims**

1. Electronic device, particularly a transmitter for measuring a process measured variable, wherein the electronic device can be operated by a magnetic body, wherein the electronic device has an operating mode "with magnet" and a second operating mode "without magnet", wherein the electronic device comprises:

EP 2 633 624 B1

a housing (10), which has at least one chamber (12) in the interior of said housing;
a magnetic body guide (14) designed to hold and guide the magnetic body (30), wherein the magnetic body guide enables the positioning of a magnetic body, which has been received, in at least two defined magnetic body positions (a, b) in relation to the housing;
a control and evaluation circuit (20), which is arranged in the chamber, with
a first Hall effect sensor (22) designed to capture at least one component of a first local magnetic field at the place of the first Hall effect sensor and to provide a first signal which depends on the local magnetic field measured at the first place, wherein the first Hall effect sensor has a first defined position in relation to the housing, and
a second Hall effect sensor (24) designed to capture at least one component of a second local magnetic field at the place of the second Hall effect sensor and to provide a second signal which depends on the local magnetic field measured at the second place, wherein the second Hall effect sensor has a second defined position in relation to the housing;
wherein, during commissioning, the control circuit is suitable for determining whether a magnetic body is present in the magnetic body guide using the first signal ($S_1$) or a first digital state variable ($Z_1$) derived therefrom, and using a second signal ($S_2$) or a second digital state variable ($Z_2$) derived therefrom,
wherein, if there is a magnetic body present, the device goes to the "with magnet" operating mode,
wherein the control circuit uses one of the signals or both of the signals ($S_1$, $S_2$) or a digital state variable or both digital state variables ($Z_1$, $Z_2$) to determine whether the magnetic body is in the first defined magnetic body position or has been displaced from this position, particularly by at least a reference value, in order to recognize control commands, and
wherein, if a magnetic body is not present, the device goes to the "without magnet" operating mode in which signals ($S_1$, $S_2$) of the Hall effect sensors are no longer evaluated.

2. Electronic device as claimed in Claim 1, wherein the magnetic body guide comprises a blind hole in the housing and wherein the first defined magnetic body position in the longitudinal direction of the blind hole is at a distance from the second defined magnetic body position.

3. Electronic device as claimed in Claim 2, wherein the first Hall effect sensor is positioned in order to capture a component of the magnetic field which is essentially perpendicular to the longitudinal direction of the blind hole.

4. Electronic device as claimed in Claim 2 or 3, wherein the second Hall effect sensor is positioned in order to capture a component of the magnetic field which is essentially perpendicular to the longitudinal direction of the blind hole.

5. Electronic device as claimed in Claim 4, wherein the value of the component of the local magnetic field that is captured with the first Hall effect sensor has an opposite sign to the value of the component of the local magnetic field that is captured with the second Hall effect sensor if there is a magnetic body in the magnetic body guide and if the magnetic body is positioned in a first defined magnetic body position (a).

6. Electronic device as claimed in Claim 4, wherein the following applies for the value of a ratio R of a signal sum to a signal difference of the signals $S_1$, $S_2$ of the Hall effect sensors, which represent the components measured by the first and second Hall effect sensor:

$$R := |(S_1 + S_2)| / (|S_1| + |S_2|) < m,$$

wherein m = 0.4, particularly m = 0.2, preferably m = 0.1,
if a magnetic body is located in the magnetic body guide and if the magnetic body is positioned in a first defined magnetic body position (a).

7. Electronic device as claimed in Claim 6, wherein the control and evaluation circuit has an input to receive the signals $S_1$, $S_2$, of the first and second Hall effect sensor and is designed in such a way to determine the presence of a magnetic body in the first defined magnetic body position if R < m.

8. Electronic device as claimed in one of the previous claims, wherein the control and evaluation circuit has an input to receive the signals $S_1$, $S_2$, of the first and second Hall effect sensor and a discriminator circuit to map the signals $S_1$, $S_2$ of the Hall effect sensors to defined state values $Z_1$, $Z_2$, which can each adopt a value from the group {-1; 0; +1}, and wherein the control and evaluation circuit is designed to determine the presence of a magnetic body in the first defined magnetic body position if $Z_1 \neq Z_2$.

9. Electronic device as claimed in Claim 8, wherein the defined state values $Z_1$, $Z_2$ can each adopt a value from the group {0; 1}, and wherein the control and evaluation circuit is designed to determine the presence of a magnetic body in the first defined magnetic body position if ($Z_1 = 0$ and $Z_2 = 1$) or ($Z_1 = 1$ and $Z_2 = 0$).

10. Electronic device as claimed in one of the previous claims, wherein the following applies for the distance a of the first Hall sensor from the second Hall effect sensor in the direction of the movement of the magnetic body guide: $a > l/4$, particularly $a > l/2$ and preferably $a > l/2l$, wherein l is the longitudinal extension of the magnetic body in the direction of movement of the magnetic body guide.

11. Electronic device as claimed in one of the previous claims, wherein the process measured variable is the pressure, level, temperature, flow, pH value, conductivity, turbidity, concentration of dissolved oxygen, an analytical sum parameter such as the total organic carbon, or another property of a process medium.


**Revendications**

1. Appareil électronique, notamment un transmetteur destiné à la mesure d'une grandeur de process, l'appareil électronique pouvant être utilisé au moyen d'un corps magnétique, l'appareil électronique présentant un mode de fonctionnement "avec aimant" et un deuxième mode de fonctionnement "sans aimant", l'appareil électronique comprenant :

  un boîtier (10), dont l'intérieur comprend au moins une chambre (12) ;
  un guide de corps magnétique (14) destiné au logement et au guidage du corps magnétique (30), le guide de corps magnétique permettant le positionnement d'un corps magnétique installé dans au moins deux positions de corps magnétique définies (a, b) par rapport au boîtier ;
  un circuit de commande et d'exploitation (20), disposé dans la chambre, avec
  un premier capteur à effet Hall (22) destiné à mesurer au moins une composante d'un premier champ magnétique local sur l'emplacement du premier capteur à effet Hall, et à mettre à disposition un premier signal dépendant du champ magnétique local mesuré sur le premier emplacement, le premier capteur à effet Hall présentant par rapport au boîtier une première position définie, et
  un deuxième capteur à effet Hall (24) destiné à mesurer au moins une composante d'un deuxième champ magnétique local sur l'emplacement du deuxième capteur à effet Hall, et à mettre à disposition un deuxième signal dépendant du champ magnétique local mesuré sur le deuxième emplacement, le deuxième capteur à effet Hall présentant par rapport au boîtier une deuxième position définie ;

  pour lequel le circuit de commande est approprié, lors la mise en service, sur la base du premier signal ($S_1$) ou d'une grandeur d'état numérique ($Z_1$) en résultant et sur la base du deuxième signal ($S_2$) ou d'une grandeur d'état numérique ($Z_2$) en résultant, à déterminer la présence ou non d'un corps magnétique dans le guide de corps magnétique,
  si oui, l'appareil passant en mode de fonctionnement "avec aimant",
  en ce que le circuit de commande détermine, sur la base d'un des signaux ou des deux signaux ($S_1$, $S_2$) ou d'une grandeur d'état numérique ou des deux grandeurs d'état numériques ($Z_1$, $Z_2$), si le corps magnétique se trouve dans la première position de corps magnétique définie ou a été déplacé de cette position, notamment d'au moins une valeur de référence, afin de détecter des instructions de commande, et si non, l'appareil passe en mode de fonctionnement "sans aimant", dans lequel les signaux ($S_1$, $S_2$) des capteurs à effet Hall ne sont plus exploités.

2. Appareil électronique selon la revendication 1, pour lequel le guide de corps magnétique comprend un trou borgne dans le boîtier, et pour lequel la première position définie du corps magnétique est espacée dans la direction longitudinale par rapport à la deuxième position définie du corps magnétique.

3. Appareil électronique selon la revendication 2, pour lequel le premier capteur à effet Hall est positionné de telle sorte à mesurer une composante du champ magnétique, qui est pour l'essentiel perpendiculaire à la direction longitudinale du trou borgne.

4. Appareil électronique selon la revendication 2 ou 3, pour lequel le deuxième capteur à effet Hall est positionné de telle sorte à mesurer une composante du champ magnétique, qui est pour l'essentiel perpendiculaire à la direction longitudinale du trou borgne.

5. Appareil électronique selon la revendication 4, pour lequel la valeur de la composante du champ magnétique local, mesurée avec le premier capteur à effet Hall, présente un signe contraire à la valeur de la composante du champ magnétique local, mesurée avec le deuxième capteur à effet Hall, lorsqu'un corps magnétique se trouve dans le guide de corps magnétique, et lorsque le corps magnétique est positionné dans une première position de corps magnétique définie (a).

6. Appareil électronique selon la revendication 4, pour lequel la valeur d'un rapport R entre la somme et la différence des signaux $S_1$, $S_2$ des capteurs à effet Hall, qui représentent les composantes mesurées respectivement par le premier et le deuxième capteur à effet hall, est défini comme suit :

$$R := |(S_1 + S_2)| / (|S_1| + |S_2|) < m,$$

où $m = 0,4$, notamment $m = 0,2$, de préférence $m = 0,1$,
lorsqu'un corps magnétique se trouve dans le guide de corps magnétique et lorsque le corps magnétique est positionné dans une première position de corps magnétique définie (a).

**7.** Appareil électronique selon la revendication 6, pour lequel le circuit de commande et d'exploitation comporte une entrée pour la réception des signaux $S_1$, $S_2$, du premier et du deuxième capteur à effet hall, et est conçu de telle sorte à déterminer la présence d'un corps magnétique dans la première position de corps magnétique définie lorsque $R < m$.

**8.** Appareil électronique selon l'une des revendications précédentes, pour lequel le circuit de commande et d'exploitation comporte une entrée pour la réception des signaux $S_1$, $S_2$, du premier et du deuxième capteur à effet hall et un circuit discriminateur destiné à transposer les signaux $S_1$, $S_2$ des capteurs à effet hall sur des valeurs d'état définies $Z_1$, $Z_2$, qui peuvent adopter chacune une valeur issue de l'ensemble {-1; 0; +1}, et le circuit de commande et d'exploitation étant conçu de telle sorte à déterminer la présence d'un corps magnétique dans la première position de corps magnétique définie lorsque $Z_1 \neq Z_2$.

**9.** Appareil électronique selon la revendication 8, pour lequel les valeurs d'état définies $Z_1$, $Z_2$ peuvent adopter chacune une valeur issue de l'ensemble {0; 1}, et le circuit de commande et d'exploitation étant conçu de telle sorte à déterminer la présence d'un corps magnétique dans la première position de corps magnétique définie lorsque ($Z_1 = 0$ et $Z_2 = 1$) ou ($Z_1 = 1$ et $Z_2 = 0$).

**10.** Appareil électronique selon l'une des revendications précédentes, pour lequel s'applique la relation suivante pour la distance a du premier capteur à effet Hall par rapport au deuxième capteur à effet Hall en direction du mouvement du guide de corps magnétique :

$a > l/4$, notamment $a > l/2$ et de préférence $a > l/2l$, où l est l'extension longitudinale du corps magnétique en direction du mouvement du guide de corps magnétique.

**11.** Appareil électronique selon l'une des revendications précédentes, pour lequel la grandeur de process concerne la pression, le niveau, la température, le débit, le pH, la conductivité, la turbidité, la concentration de l'oxygène dissous, un paramètre global analytique tel que la teneur totale en carbone organique, ou une autre propriété du fluide de process.

**Fig.1a**

**Fig.1b**

EP 2 633 624 B1

**Fig.3a**

**Fig.2**

**Fig.3c**

120

140

142

$k_3 <$
$S_2 < k_4$

Nein

Ja

Taster in
Ruhestellung

Taster
betätigt

**Fig.3b**

120

110

122

124

130

140

$|S_1| > k_1$

Nein

Ja

$\dfrac{|(S_1 + S_2)|}{(|S_1| + |S_2|)} < k_2$

Nein

Ja

Empfange $S_1$, $S_2$

↓

Wandle zu $Z_1$, $Z_2$

↓

$Z1 = 1$ und $Z2 = 0$
oder
$Z1 = 0$ und $Z2 = 1$

Nein →  Betriebsmodus

„Ohne Magnet"

Ja

Betriebsmodus

„Mit Magnet"

**Fig.4**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102004036324 A1
- EP 0383823 B1